Europäisches Patentamt

European Patent Office

Office européen des brevets

(19)

(11)  EP 1 210 611 B1

(12)  **FASCICULE DE BREVET EUROPEEN**

(45)  Date de publication et mention
de la délivrance du brevet:
**03.12.2003  Bulletin 2003/49**

(21)  Numéro de dépôt: **00958757.7**

(22)  Date de dépôt: **29.08.2000**

(51)  Int Cl.$^7$: **G01R 29/08**

(86)  Numéro de dépôt international:
**PCT/FR00/02396**

(87)  Numéro de publication internationale:
**WO 01/020353 (22.03.2001 Gazette 2001/12)**

(54)  **PROCEDE DE MESURE ET DE DIAGNOSTIC DE RAYONNEMENTS ELECTROMAGNETIQUES**

TEST- UND MESS-VERFAHREN FÜR ELEKTROMAGNETISCHE STRAHLUNG

METHOD FOR MEASURING AND DETERMINING ELECTROMAGNETIC RADIATION

(84)  Etats contractants désignés:
**AT BE CH CY DE DK ES FI FR GB GR IE IT LI LU MC NL PT SE**

(30)  Priorité:  **10.09.1999  FR 9911364**

(43)  Date de publication de la demande:
**05.06.2002  Bulletin 2002/23**

(73)  Titulaire: **INSTITUT NATIONAL DE RECHERCHE SUR LES TRANSPORTS ET LEUR SECURITE (INRETS)**
**94110 Arcueil (FR)**

(72)  Inventeurs:
 • **KLINGLER, Marco**
**F-59000 Lille (FR)**
 • **RIOULT, Jean**
**F-59000 Lille (FR)**
 • **BOURGEAT, Laurent**
**F-75015 Paris (FR)**
 • **FLAMME, Jean-Marie**
**F-75011 Paris (FR)**

(74)  Mandataire: **Abello, Michel et al**
**Cabinet Peuscet,**
**78, avenue Raymond Poincaré**
**75116 Paris (FR)**

(56)  Documents cités:
**WO-A-93/18558          WO-A-94/04933**
**WO-A-96/12198          DE-C- 19 549 246**

 • **KOEPKE ET AL.: "implementatio of an automated system" IEEE TRANS. ON INSTR. AND MEASM., vol. 39, no. 2, avril 1989 (1989-04), pages 473-479, XP000081529 new york, us**
 • **HANSEN ET AL.: "a broadband alternative" RGE REVUE GENERALE DE L'ELECTRICITE, no. 11, décembre 1991 (1991-12), pages 30-35, XP000273406 paris, fr**

**Description**

L'objet de l'invention est un procédé de mesure et de diagnostic du rayonnement électromagnétique d'un objet alimenté électriquement, placé dans un guide d'ondes transverses électromagnétiques.

On connaît et on utilise actuellement des techniques d'évaluation du rayonnement électromagnétique d'un objet alimenté électriquement et testé dans un guide d'ondes électromagnétiques métallique, dont l'état électromagnétique est précisé en tout point de son volume par un vecteur champ électrique et un vecteur champ magnétique. Lorsque les dimensions transversales du guide d'ondes sont petites par rapport aux longueurs d'onde considérées, les ondes électromagnétiques se propagent dans le guide d'ondes en mode Transverse Electromagnétique (TEM). Dans ces conditions, on sait que le vecteur champ électrique et le vecteur champ magnétique sont situés dans un plan transverse perpendiculaire à l'axe de propagation des ondes et ont des orientations géométriquement définies par rapport aux organes constitutifs du guide d'ondes électromagnétiques comme il est précisé dans le livre « Field Theory of Guided Waves », McGraw-Hill Book Company, New York, 1960 (R. E. Collin).

Ces techniques reposent uniquement sur des mesures d'amplitude de tension ou de puissance au(x) port(s) du guide d'ondes transverses électromagnétiques dans le domaine des fréquences. Ces techniques se distinguent par le nombre de positionnements de l'objet sous test dans le guide d'ondes et par les dispositions relatives de ces positionnements en fonction du degré de pertinence souhaité pour les résultats, comme il est précisé dans le rapport du National Bureau of Standards N° TN-1059 (PB83-165274) d'octobre 1982 : « A Method to Quantify the Radiation Characteristics of an Unknown Interference Source » (M.T. Ma et G.H. Koepke).

Les résultats obtenus par ces techniques fournissent soit la puissance totale rayonnée en espace libre (sans plan réfléchissant), soit le diagramme de rayonnement obtenu avec ou sans plan réfléchissant comme indiqué dans la publication IEEE Transactions on Electromagnetic Compatibility, Vol. 37, N°1, de février 1995 : « On Correlating TEM Cell and OATS Emission Measurements » (P. Wilson) ainsi que dans les demandes internationales PCT WO 93/18558, WO 94/04933 et WO 96/12198, et comme présenté au 13ème Symposium et Exhibition Technique sur la Compatibilité Electromagnétique de Zurich (16-18 février 1999) dans la communication « Wide-band Total Radiated Power Measurements of Electronic Equipment in TEM and GTEM cells » (M. Klingler, J. Rioult, J.P. Ghys et S. Ficheux).

Les mesures dans le domaine des fréquences ne permettent pas d'obtenir les valeurs des phases sur le(s) port(s) ni les valeurs de différence de phases entre les ports lorsque le rayonnement électromagnétique de l'objet à tester est composé de plusieurs fréquences. Ces mesures ne fournissent donc qu'une information partielle du rayonnement électromagnétique de l'objet sous test. Il est alors très difficile d'interpréter ces résultats en vue d'obtenir un diagnostic du rayonnement électromagnétique de l'objet sous test et d'améliorer la conception de cet objet sur le plan de son comportement électromagnétique.

La présente invention a pour but de remédier à cette lacune en déterminant des grandeurs caractéristiques du pouvoir rayonnant des courants véhiculés dans les conducteurs de l'objet sous test, permettant ainsi un diagnostic des émissions électromagnétiques dudit objet. Dans la suite de cette description et des revendications, on utilise le qualitatif temporel pour exprimer une variation en fonction du temps. Pour atteindre le but du procédé objet de la présente invention, on détermine des grandeurs géométriques élémentaires, à savoir des longueurs équivalentes de segments de conducteurs virtuels et les surfaces équivalentes de boucles de conducteurs virtuels qui produiraient le même rayonnement électromagnétique s'ils étaient parcourus par lesdits courants, à partir d'une part des évolutions temporelles des courants véhiculés dans les conducteurs de l'objet sous test, ces évolutions étant connues au moment de l'analyse, et d'autre part à partir des évolutions temporelles des tensions mesurées au(x) port(s) du guide d'ondes. Contrairement aux techniques connues, la mesure des évolutions temporelles des tensions recueillies au(x) port(s) du guide d'ondes permet, par traitement numérique, d'obtenir une information complète du rayonnement électromagnétique de l'objet sous test, ce qui est un avantage déterminant du procédé selon l'invention par rapport aux techniques connues. Il est alors possible d'interpréter ces résultats en vue d'obtenir un diagnostic du rayonnement électromagnétique de l'objet sous test et d'améliorer la conception de cet objet sur le plan de son comportement électromagnétique.

Plus précisément, le procédé décrit dans la présente invention est un procédé de mesure et de diagnostic du rayonnement électromagnétique d'un objet dont les conducteurs sont parcourus par des courants, ledit objet étant placé dans un guide d'ondes transverses électromagnétiques qui comporte au moins un port, procédé dans lequel on prend en compte les évolutions temporelles desdits courants, on réalise un enregistrement temporel de 2n mesures de tension sur le(s) port(s) du guide d'ondes transverses électromagnétiques et on traite numériquement les valeurs desdits courants et desdites mesures de tension pour déterminer les grandeurs géométriques élémentaires caractéristiques du pouvoir rayonnant de chaque courant véhiculé.

Le procédé selon l'invention peut être mis en oeuvre dans un guide d'ondes transverses électromagnétiques comportant un ou deux ports.

Lorsque le guide d'ondes transverses électromagnétiques comporte deux ports, le procédé selon l'invention peut notamment être mis en oeuvre de quatre manières différentes auxquelles correspondent les variantes un à quatre du procédé objet de l'invention.

Selon la première variante, on procède à l'enregistrement simultané des tensions recueillies sur chacun des deux ports du guide d'ondes transverses électromagnétiques, cet enregistrement étant répété pour n positionnements de l'objet dans le guide d'ondes.

Selon la seconde variante, on procède à l'enregistrement de la tension recueillie sur un seul des deux ports du guide d'ondes transverses électromagnétiques, ce port étant choisi arbitrairement et cet enregistrement étant répété pour n couples de deux positionnements de l'objet dans le guide d'ondes, deux positionnements d'un même couple se déduisant l'un de l'autre par une rotation de 180 degrés autour de l'axe du vecteur champ électrique.

Selon la troisième variante, on procède à l'enregistrement de la tension recueillie sur un seul des deux ports du guide d'ondes transverses électromagnétiques, ce port étant choisi arbitrairement et cet enregistrement étant répété pour n couples de deux positionnements de l'objet dans le guide d'ondes, deux positionnements d'un même couple se déduisant l'un de l'autre par une rotation de 180 degrés autour de l'axe du vecteur champ magnétique.

Selon la quatrième variante, on procède à l'enregistrement de la tension recueillie sur l'un des deux ports du guide d'ondes transverses électromagnétiques, puis à l'enregistrement de la tension recueillie sur l'autre port, sans changer le positionnement de l'objet sous test, ce couple d'enregistrements étant répété pour n positionnements de l'objet dans le guide d'ondes transverses électromagnétiques.

Lorsque le guide d'ondes transverses électromagnétiques ne comporte qu'un port, le procédé objet de l'invention peut être mis en oeuvre de deux manières différentes auxquelles correspondent les variantes cinq et six du procédé objet de l'invention.

Selon la cinquième variante, on procède à l'enregistrement de la tension recueillie sur le port, cet enregistrement étant répété pour n couples de deux positionnements de l'objet dans le guide d'ondes transverses électromagnétiques, ces deux positionnements se déduisant l'un de l'autre par une rotation de 180 degrés autour de l'axe du vecteur champ électrique.

Selon la sixième variante, on procède à l'enregistrement de la tension recueillie sur le port, cet enregistrement étant répété pour n couples de deux positionnements de l'objet dans le guide d'ondes transverses électromagnétiques, ces deux positionnements se déduisant l'un de l'autre par une rotation de 180 degrés autour de l'axe du vecteur champ magnétique.

Pour mieux faire comprendre la substance de l'invention, on décrit ci-dessous diverses variantes de mise en oeuvre du procédé selon l'invention, données à titre d'exemple et illustrées aux figures 1 à 15 des dessins. Sur ces dessins :

La figure 1 représente schématiquement et en perspective, avec vue partielle de l'intérieur, un guide d'ondes transverses électromagnétiques à deux ports, de forme principalement parallélépipédique.

La figure 2 représente schématiquement et en perspective, avec vue partielle de l'intérieur, un guide d'ondes transverses électromagnétiques à un port, de forme pyramidale.

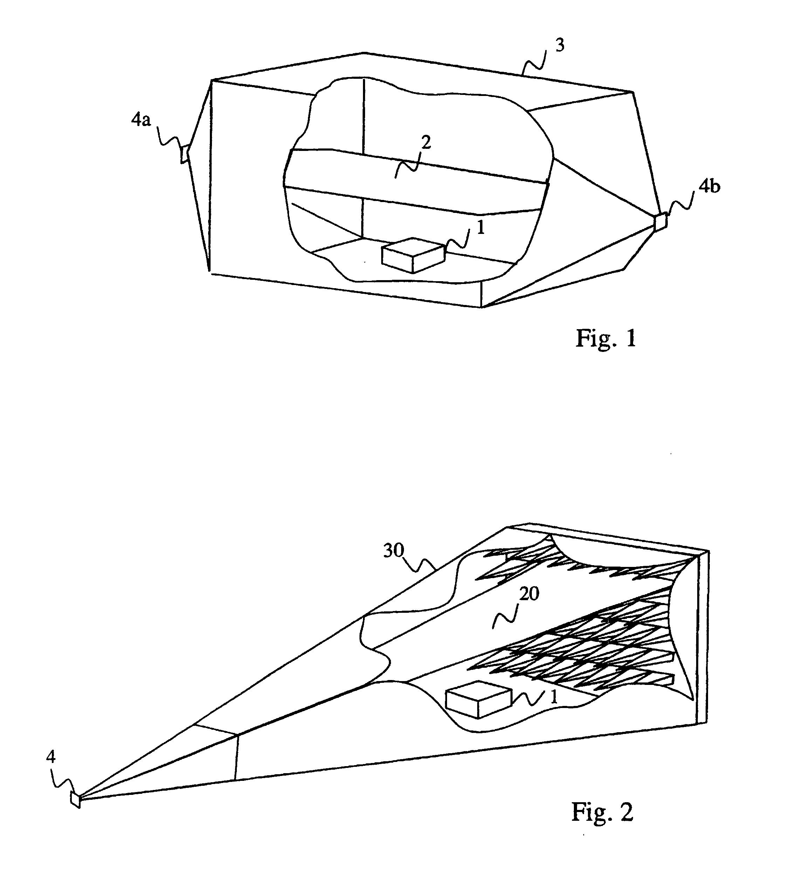

Les guides d'ondes représentés aux figures 1 et 2 sont des appareils connus et utilisés actuellement. Ils sont également utilisés pour mettre en oeuvre le procédé de mesure et de diagnostic du rayonnement électromagnétique conforme à la présente invention.

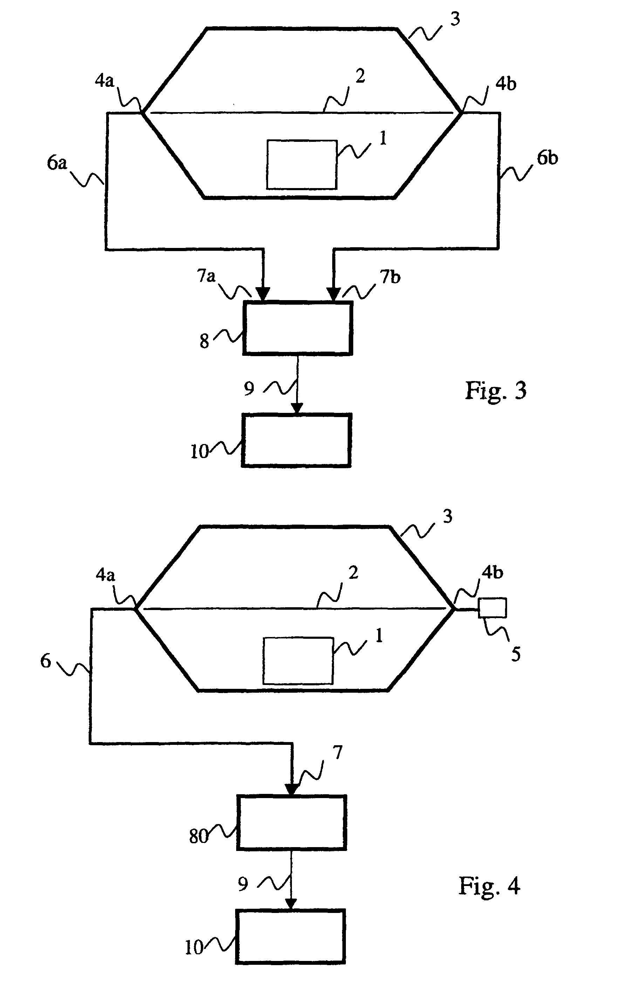

Les figures 3 et 4 sont des coupes longitudinales schématiques du guide d'ondes transverses électromagnétiques à deux ports, présenté à la figure 1. La première variante de mise en oeuvre du procédé objet de l'invention correspond à la figure 3 et exploite simultanément les deux ports du guide d'ondes. Les deuxième et troisième variantes de mise en oeuvre du procédé objet de l'invention correspondent à la figure 4 et exploitent indifféremment un seul des deux ports. La quatrième variante de mise en oeuvre du procédé objet de l'invention correspond également à la figure 4 et exploite successivement les deux ports.

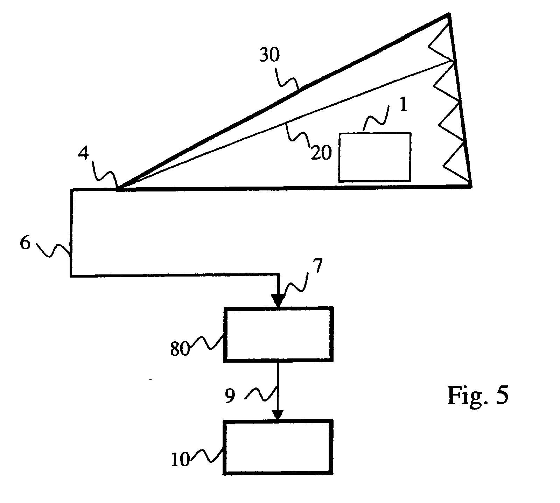

La figure 5 est une coupe longitudinale schématique du guide d'ondes transverses électromagnétiques à un port présenté à la figure 2, ce guide est utilisé pour la mise en oeuvre du procédé objet de la présente invention selon les cinquième et sixième variantes de l'invention.

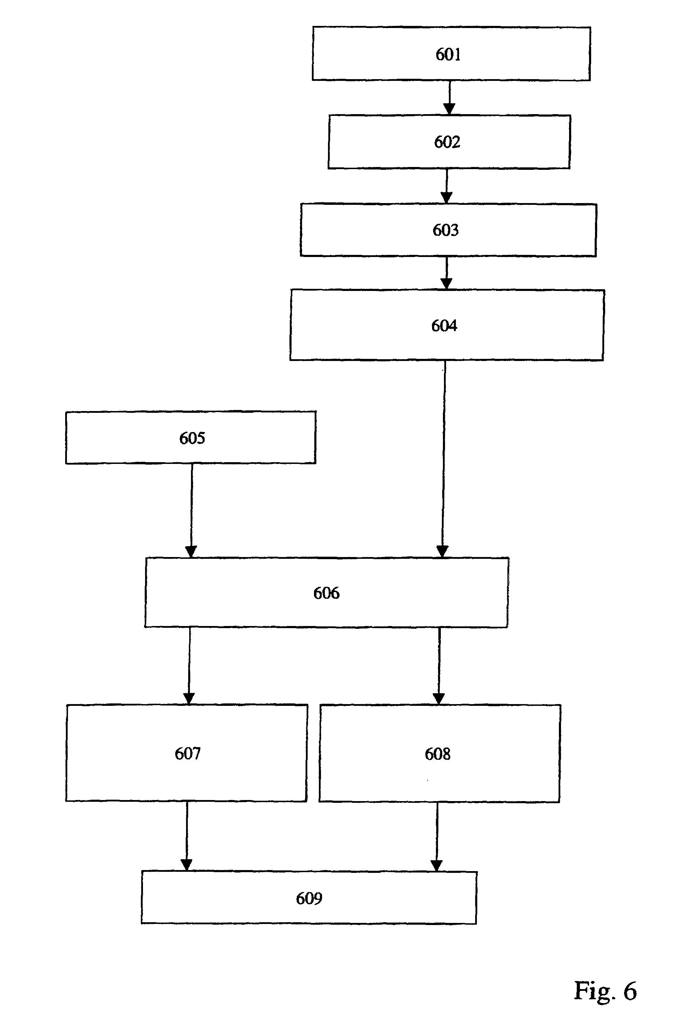

La figure 6 montre l'organigramme des différentes étapes du procédé objet de l'invention selon la première variante.

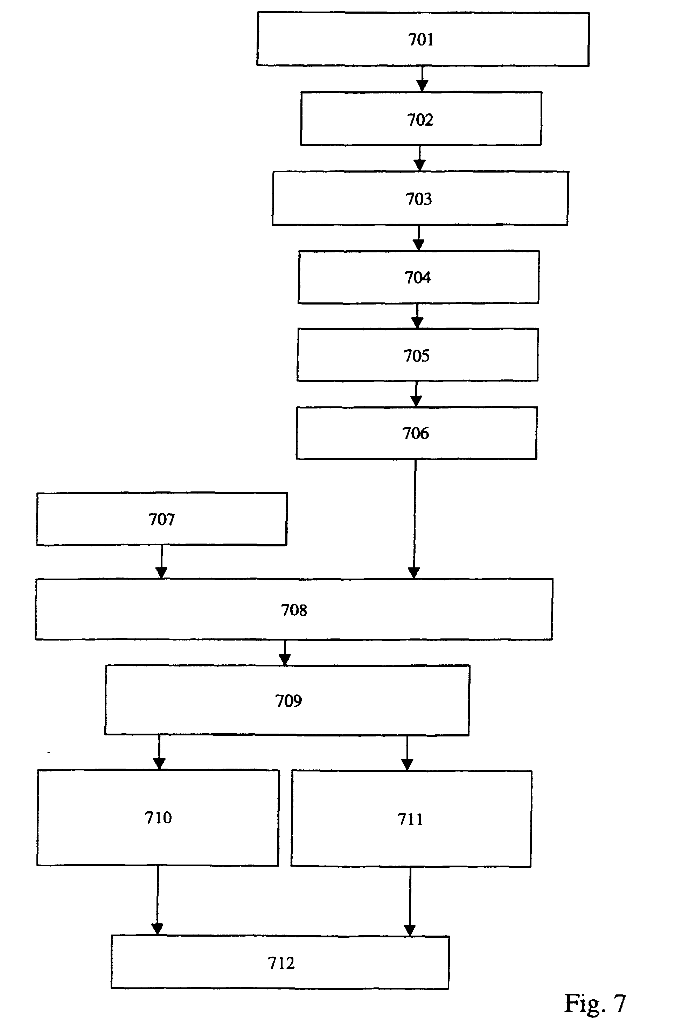

La figure 7 montre l'organigramme des différentes étapes du procédé objet de l'invention selon les deuxième, troisième, cinquième ou sixième variantes.

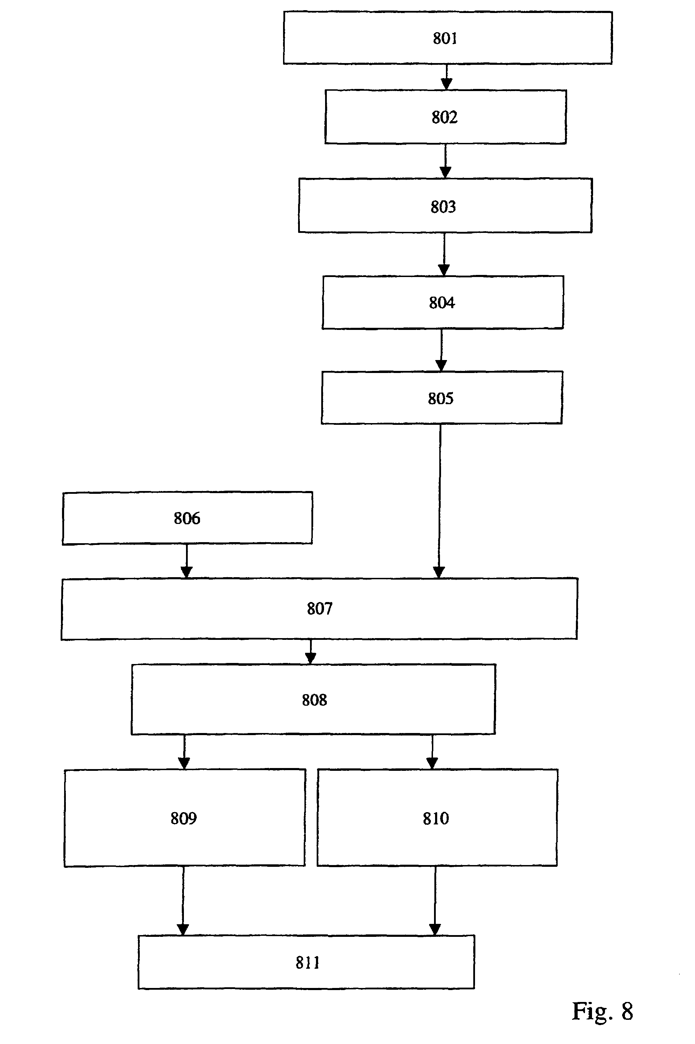

La figure 8 montre l'organigramme des différentes étapes du procédé objet de l'invention selon la quatrième variante.

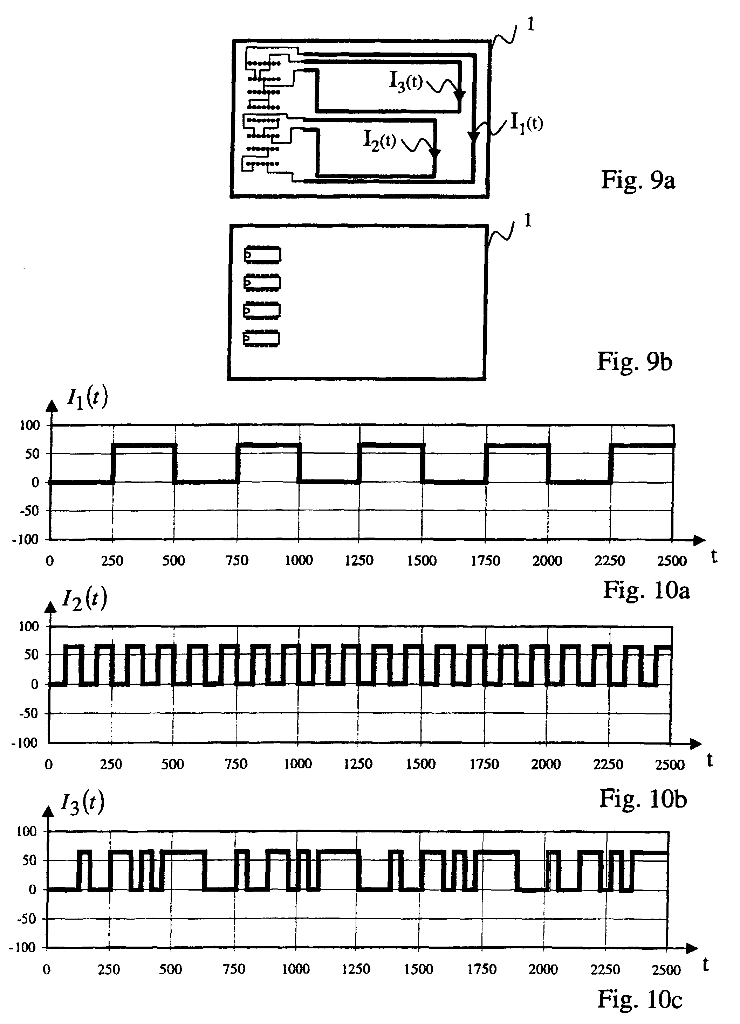

Les figures 9a et 9b montrent schématiquement un objet à tester. La figure 9a représente une des faces de l'objet et la figure 9b représente l'autre face.

Les figures 10a, 10b et 10c montrent l'évolution temporelle des courants qui parcourent l'objet lors de son test. Sur ces figures, l'axe des abscisses représente le temps exprimé en nano-secondes et l'axe des ordonnées représente la valeur des courants exprimés en milli-ampères.

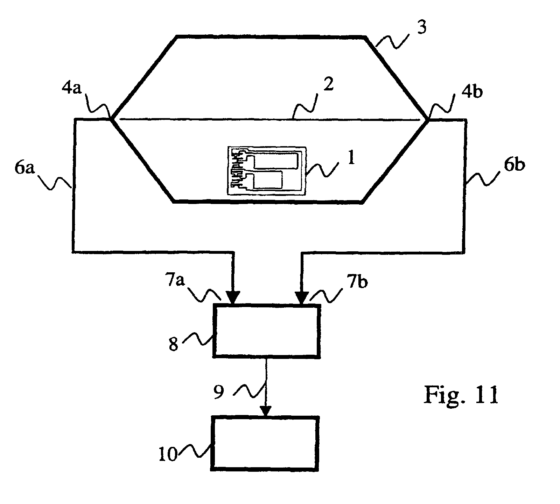

La figure 11 représente schématiquement un guide d'ondes transverses électromagnétiques à deux ports dans lequel est placé un objet sous test et auquel le procédé objet de l'invention est appliqué selon la première variante.

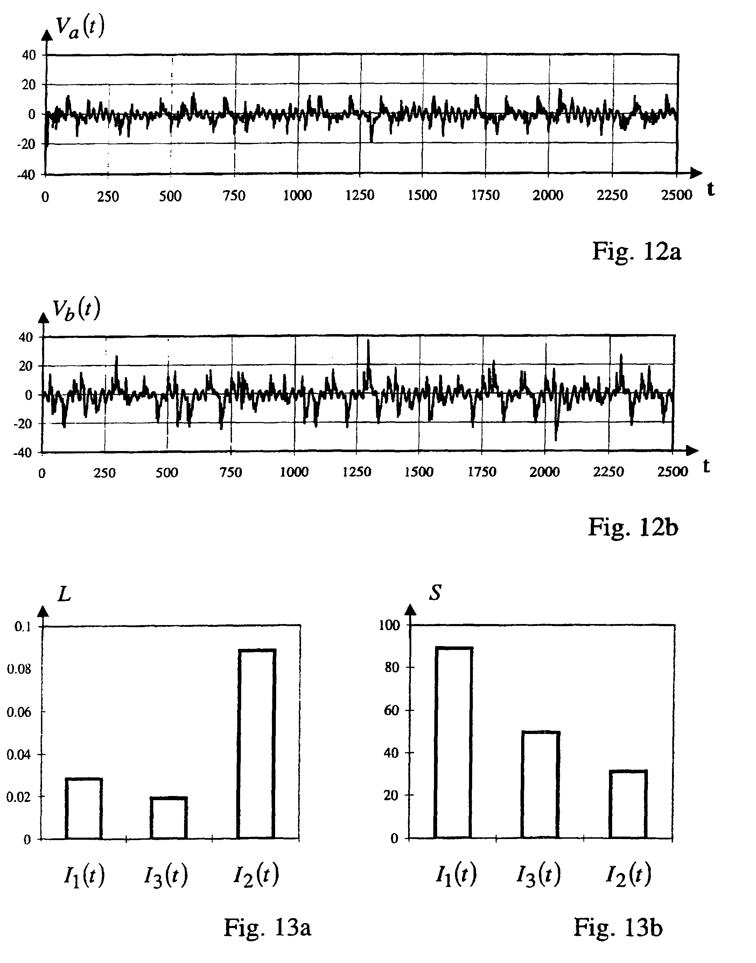

Les figures 12a et 12b montrent l'évolution temporelle des tensions recueillies aux deux ports du guide d'ondes transverses électromagnétiques schématisé à la figure 11. Sur ces figures, l'axe des abscisses représente le temps exprimé en nano-secondes et l'axe des ordonnées représente la valeur des tensions exprimées en milli-volts.

Les figures 13a et 13b montrent les résultats obtenus à partir des enregistrements présentés aux figures 12a et 12b et des évolutions temporelles des courants présentées aux figures 10a, 10b et 10c. Sur la figure 13a, l'axe des ordonnées représente les longueurs équivalentes de segments de conducteurs virtuels exprimées en centimètres pour chaque courant indiqué en abscisse. Sur la figure 13b, l'axe des ordonnées représente les surfaces équivalentes de boucles de conducteurs virtuels exprimées en $cm^2$ pour chaque courant indiqué en abscisse.

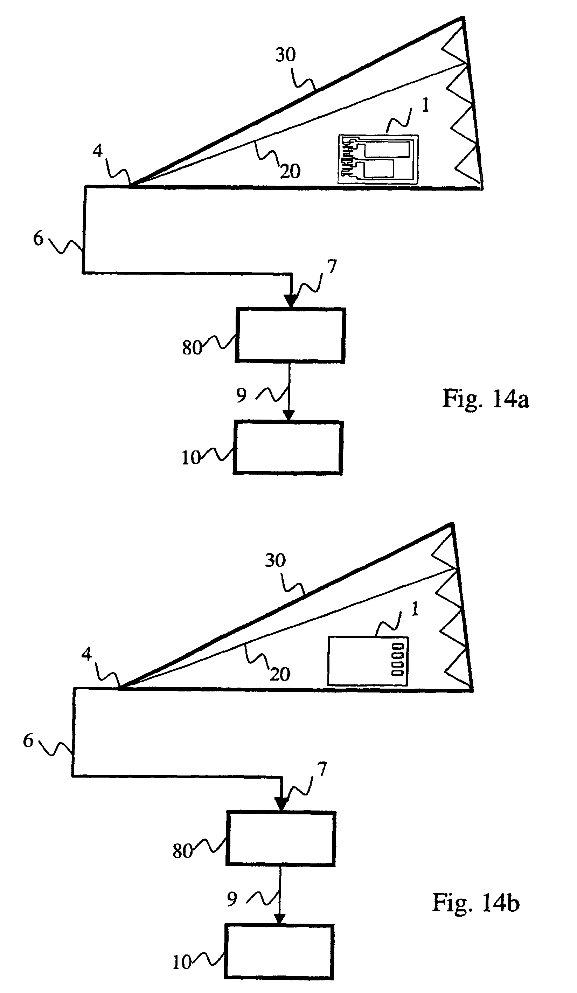

Les figures 14a et 14b représentent schématiquement un guide d'ondes transverses électromagnétiques à un port dans lequel l'objet sous test est placé dans deux positions qui se déduisent l'une de l'autre par une rotation de 180 degrés autour de l'axe du vecteur champ électrique et auquel le procédé objet de l'invention est appliqué respectivement selon la cinquième variante.

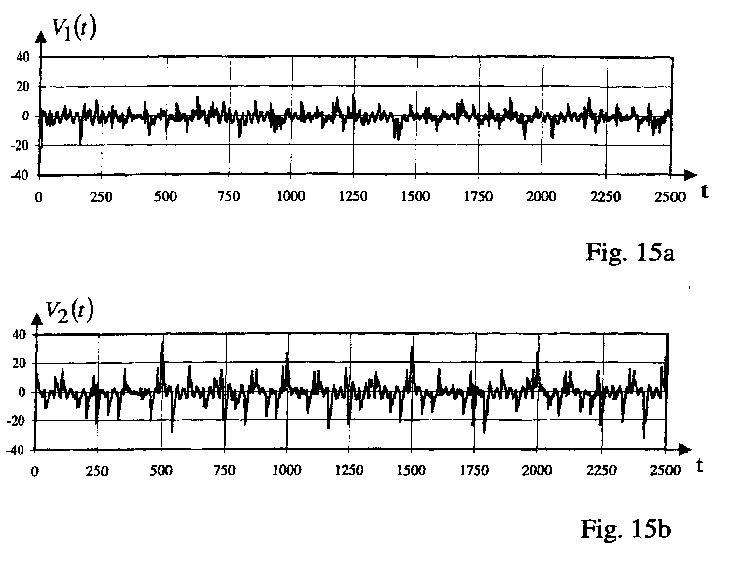

Les figures 15a et 15b montrent l'évolution temporelle des tensions recueillies au port du guide d'ondes transverses électromagnétiques schématisé aux figures 14a et 14b. Sur ces figures, l'axe des abscisses représente le temps exprimé en nano-secondes et l'axe des ordonnées représente la valeur des tensions exprimées en milli-volts.

Sur les figures 1 à 5 ainsi que sur les figures 11, 14a et 14b on voit l'objet 1 dont on veut mesurer le rayonnement électromagnétique et pour lequel on veut porter un diagnostic (objet sous test), le conducteur interne du guide d'ondes 2 ou 20 selon le cas, raccordé au port 4 ou aux ports 4a et 4b selon le cas, le conducteur externe du guide d'ondes 3 ou 30 selon le cas, aux extrémités duquel sont fixés le ports 4 ou les ports 4a et 4b selon le cas.

Sur les figures 3 à 5 ainsi que sur les figures 11, 14a et 14b on voit des conducteurs 6, 6a et 6b reliés respectivement, d'une part aux ports 4, 4a et 4b, et d'autre part aux bornes d'entrée 7, 7a et 7b d'un enregistreur 8 ou 80 selon le cas ; le conducteur 9 relie la sortie de l'enregistreur 8 ou 80 selon le cas au dispositif de diagnostic 10.

Sur la figure 4, on voit en 5 une charge d'adaptation du guide d'ondes et sa connexion, placée sur le port 4b non raccordé à l'enregistreur 80.

Sur les figures 1 et 2, on peut voir qu'un guide d'ondes transverses électromagnétiques est constitué d'une part d'un conducteur extérieur fermé ou non, et d'autre part d'un conducteur intérieur en forme de plaque, séparant le volume intérieur du guide d'ondes en deux volumes symétriques ou non, relié au port 4 ou aux ports 4a et 4b selon le cas.

Lorsque les dimensions transversales du guide d'ondes sont petites par rapport aux longueurs d'onde considérées, les dimensions d'un objet placé dans ledit guide d'ondes sont également petites par rapport aux longueurs d'onde. Le rayonnement électromagnétique dudit objet parcouru par un ensemble de courants peut alors être représenté par un vecteur moment électrique $\vec{M}_e$ et un vecteur moment magnétique $\vec{M}_m$ repérés en un point central de l'objet sous test. Les figures 9a et 9b montrent schématiquement et à titre d'exemple, un objet à tester 1 parcouru par trois courants $I_1(t)$, $I_2(t)$ et $I_3(t)$. Les évolutions temporelles de ces courants sont connues par ailleurs. Les figures 10a, 10b et 10c montrent, à titre d'exemple, ces évolutions temporelles pour l'objet sous test 1 schématisé aux figures 9a et 9b.

Dans un guide d'ondes à deux ports 4a et 4b tel que représenté aux figures 3 et 11, utilisé selon la première variante du procédé objet de l'invention, on enregistre simultanément l'évolution temporelle des tensions $V_a(t)$ et $V_b(t)$ respectivement sur les ports 4a et 4b pour une position quelconque de l'objet sous test 1 dans le guide d'ondes. Ces tensions $V_a(t)$ et $V_b(t)$ sont les images des vecteurs moments électrique $\vec{M}_e$ et magnétique $\vec{M}_m$ et leurs évolutions temporelles sont montrées à titre d'exemple aux figures 12a et 12b. Les relations entre ces tensions et ces moments sont précisées mathématiquement par les formules suivantes :

$$V_a(t) \ = \ -\frac{e_0}{2}\left[M_{ez}(t-\Delta_a)+\frac{1}{C}\frac{\partial M_{mx}(t-\Delta_a)}{\partial t}\right]$$
$$V_b(t) \ = \ -\frac{e_0}{2}\left[M_{ez}(t-\Delta_b)-\frac{1}{C}\frac{\partial M_{mx}(t-\Delta_b)}{\partial t}\right] \tag{I}$$

dans lesquelles $C$ est la vitesse de propagation des ondes électromagnétiques dans le guide d'ondes, $\Delta_a$ et $\Delta_b$ sont respectivement les retards de propagation connus correspondant aux distances entre l'objet sous test et les ports 4a et 4b, $M_{ez}(t)$ est l'évolution temporelle de la projection du moment électrique sur l'axe du vecteur champ électrique, $M_{mx}(t)$ est l'évolution temporelle de la projection du moment magnétique sur l'axe du vecteur champ magnétique, et $e_o$ un coefficient fonction des caractéristiques géométriques et physiques du guide d'ondes.

Lorsque l'objet sous test 1, constitué d'un ensemble de conducteurs, est représenté par des segments de conducteurs virtuels de longueur équivalente $L_j$ et par des boucles de conducteurs virtuels de surface équivalente $S_j$,

parcourus par un ensemble de *m* courants $I_j(t)$, les évolutions temporelles des projections des moments électrique et magnétique de l'objet sous test sont précisées par les formules suivantes :

$$M_{ez}(t) \; = \; \sum_{j=1}^{m} L_j \, I_j\big(t - \tau_j\big)$$

$$M_{mx}(t) \; = \; \sum_{j=1}^{m} S_j \, I_j\big(t - \tau_j\big)$$

( II )

où les valeurs $\tau_j$ sont les retards des courants par rapport à une référence temporelle choisie arbitrairement et commune à l'ensemble des courants $I_j(t)$.

Le système d'équations (I) permet d'obtenir les évolutions temporelles des moments électrique $M_{ez}(t)$ et magnétique $M_{mx}(t)$ par la mesure simultanée des évolutions temporelles des tensions $V_a(t)$ et $V_b(t)$.

Le système d'équations (II) permet de retrouver la contribution de chaque courant $I_j(t)$ aux moments électrique $M_{ez}(t)$ et magnétique $M_{mx}(t)$ par identification ou corrélation selon les techniques connues. On obtient ainsi l'ensemble des couples $(L_j, \tau_j)$ et $(S_j, \tau_j)$, dans lesquels les longueurs équivalentes de segments de conducteurs virtuels $L_j$ et les surfaces équivalentes de boucles de conducteurs virtuels $S_j$ définissent les coefficients de rayonnement associés à chaque courant $I_j(t)$ pour la position de l'objet sous test 1 dans le guide d'ondes, contrairement aux techniques connues exploitant le même guide d'ondes, qui ne donnent qu'une mesure de la puissance du champ électromagnétique rayonné dû à l'ensemble des courants $I_j(t)$ considérés globalement pour cette seule position de l'objet sous test 1. Pour l'exemple correspondant aux évolutions temporelles des courants $I_1(t)$, $I_2(t)$ et $I_3(t)$ représentées aux figures 10a, 10b et 10c ainsi qu'aux évolutions temporelles $V_a(t)$ et $V_b(t)$ représentées aux figures 12a et 12b, les longueurs équivalentes de segments de conducteurs virtuels $L_j$ et les surfaces équivalentes de boucles de conducteurs virtuels $S_j$ sont données aux figures 13a et 13b.

L'organigramme présenté à la figure 6 résume la description du procédé objet de l'invention selon cette première variante pour une position de l'objet sous test choisie arbitrairement. Sur cette figure, on voit les étapes 601 à 609 précisées comme suit :

601 : Positionnement de l'objet sous test ;
602 : Détermination des paramètres d'enregistrement temporel ;
603 : Configuration de l'enregistreur ;
604 : Enregistrement temporel simultané des tensions $V_a(t)$ et $V_b(t)$ sur les ports ;
605 : Connaissance des courants $I_j(t)$;
606 : Détermination des moments électriques $M_{ez}(t)$ et des moments magnétiques $M_{mx}(t)$ à partir des tensions $V_a(t)$ et $V_b(t)$ ;
607 : Détermination des longueurs équivalentes de segments de conducteurs virtuels $L_j$ et des retards $\tau_j$ par identification des courants $I_j(t)$ dans les moments électriques $M_{ez}(t)$;
608 : Détermination des surfaces équivalentes de boucles de conducteurs virtuels $S_j$ et des retards $\tau_j$ par identification des courants $I_j(t)$ dans les moments magnétiques $M_{mx}(t)$.
609 : Affichage et interprétation des résultats pour la position de l'objet sous test.

Les étapes 601 à 603 correspondent à l'initialisation et les étapes 605 à 608 correspondent au traitement numérique.

Dans un guide d'ondes à deux ports tel que représenté à la figure 4 et utilisé selon les deuxième et troisième variantes du procédé objet de l'invention, ou dans un guide d'ondes à un port tel que représenté aux figures 5, 14a et 14b et utilisé selon les cinquième et sixième variantes du procédé objet de l'invention, on enregistre l'évolution temporelle de la tension $V_1(t)$ pour une position quelconque de l'objet sous test 1 dans le guide d'ondes. Cette évolution temporelle est mesurée sur le port 4a dans le cas des deuxième ou troisième variantes du procédé, et sur le port 4 pour les cinquième ou sixième variantes du procédé objet de l'invention. Lorsqu'il s'agit des deuxième ou cinquième variante du procédé objet de l'invention, après avoir enregistré l'évolution temporelle de la tension $V_1(t)$, on repositionne l'objet sous test 1 de telle manière que cette deuxième position se déduise de la première par une rotation de 180 degrés autour de l'axe du vecteur champ électrique. Lorsqu'il s'agit des troisième ou sixième variante du procédé objet de l'invention, après avoir enregistré l'évolution temporelle de la tension $V_1(t)$, on repositionne l'objet sous test 1 de telle manière que cette deuxième position se déduise de la première par une rotation de 180 degrés autour de l'axe du vecteur champ magnétique. Pour la nouvelle position ainsi obtenue, on enregistre l'évolution temporelle de la tension $V_2(t)$ au port 4a ou au port 4 selon le cas.

On obtient ainsi les deux enregistrements $V_1(t)$ et $V_2(t)$ sur un même port, pris à partir de deux origines de temps qui diffèrent d'un retard θ. Pour l'exemple correspondant aux évolutions temporelles des courants $I_1(t)$, $I_2(t)$ et $I_3(t)$ représentées aux figures 10a, 10b et 10c, un exemple d'enregistrements des tensions $V_1(t)$ et $V_2(t)$ est montré aux figures 15a et 15b. L'enregistrement de la tension $V_1(t)$ correspond au positionnement de l'objet sous test 1 montré à la figure 14a. L'enregistrement de la tension $V_2(t)$ correspond au positionnement de l'objet sous test 1 montré à la figure 14b. Les relations entre ces tensions et les moments sont précisées mathématiquement par les formules suivantes :

$$V_1(t) = -\frac{e_o}{2}\left[ M_{ez}(t-\Delta) + \frac{1}{C}\frac{\partial M_{mx}(t-\Delta)}{\partial t} \right]$$

$$V_2(t) = -\frac{e_o}{2}\left[ \pm M_{ez}(t-\Delta-\theta) \mp \frac{1}{C}\frac{\partial M_{mx}(t-\Delta-\theta)}{\partial t} \right]$$

$$(\text{III})$$

Les symboles utilisés dans ces formules (III) ont la même signification que ceux utilisés dans les formules (I). Le retard de propagation Δ, connu, correspond à la distance entre l'objet sous test et le port où s'effectue la mesure des tensions $V_1(t)$ et $V_2(t)$. Les signes supérieurs de la deuxième équation de ces formules correspondent à une rotation de 180 degrés autour de l'axe du vecteur champ électrique tandis que les signes inférieurs correspondent à une rotation de 180 degrés autour de l'axe du vecteur champ magnétique.

Contrairement au procédé correspondant à la première variante du procédé objet de l'invention, il n'est pas possible dans ces variantes d'obtenir directement les projections des moments électrique $M_{ez}(t)$ et magnétique $M_{mx}(t)$ puisque le système de deux équations (III) comprend une inconnue supplémentaire θ.

L'indétermination de (III) peut être levée à partir de la connaissance de l'ensemble des courants $I_j(t)$ puisque $M_{ez}(t)$ et $M_{mx}(t)$ dépendent tous deux des mêmes courants par les expressions (II). La corrélation par traitement numérique entre $V_1(t)$ et $V_2(t)$ permet d'obtenir le retard θ et de déterminer l'évolution temporelle de la tension $V_2(t)$ avec la même origine de temps que celle de l'évolution de la tension $V_1(t)$. L'évolution de la tension $V_1(t)$ s'identifie à l'évolution de la tension $V_a(t)$ que l'on aurait obtenue en appliquant la première variante du procédé objet de l'invention. L'évolution de la tension $V_2(t+\theta)$, obtenue en décalant $V_2(t)$ dans le temps du retard θ, s'identifie à l'évolution de la tension $V_b(t)$ que l'on aurait obtenue en appliquant la première variante du procédé objet de l'invention.

On peut ainsi obtenir avec un guide d'ondes qui ne dispose que d'un port ou dont on ne veut utiliser qu'un seul port, les deux tensions $V_a(t)$ et $V_b(t)$ que l'on aurait obtenues avec un guide d'ondes dont on utilise simultanément les deux ports.

L'organigramme présenté à la figure 7 résume la description du procédé objet de l'invention selon ses deuxième, troisième, cinquième et sixième variantes, pour une position initiale quelconque de l'objet sous test. Sur cette figure, on voit les étapes 701 à 712 précisées comme suit :

701 : Positionnement initiale de l'objet sous test ;
702 : Détermination des paramètres d'enregistrement temporel ;
703 : Configuration de l'enregistreur ;
704 : Enregistrement de la tension $V_1(t)$ sur le port ;
705 : Repositionnement de l'objet sous test par une rotation de 180 degrés autour de l'axe du vecteur champ électrique ou magnétique selon la variante ;
706 : Enregistrement de la tension $V_2(t)$ sur le port ;
707 : Connaissance des courants $I_j(t)$ ;
708 : Détermination des tensions $V_a(t)$ et $V_b(t)$ par corrélation des tensions $V_1(t)$ et $V_2(t)$ en connaissance des courants $I_j(t)$ ;
709 : Détermination des moments électriques $M_{ez}(t)$ et des moments magnétiques $M_{mx}(t)$ à partir des tensions $V_a(t)$ et $V_b(t)$ ;
710 : Détermination des longueurs équivalentes de segments de conducteurs virtuels $L_j$ et des retards $\tau_j$ par identification des courants $I_j(t)$ dans les moments électriques $M_{ez}(t)$;
711 : Détermination des surfaces équivalentes de boucles de conducteurs virtuels $S_j$ et des retards $\tau_j$ par identification des courants $I_j(t)$ dans les moments magnétiques $M_{mx}(t)$.
712 : Affichage et interprétation des résultats pour la position de l'objet sous test.

Les étapes 701 à 703 correspondent à l'initialisation, les étapes 704 à 706 correspondent à l'enregistrement et les étapes 707 à 711 correspondent au traitement numérique.

Selon la quatrième variante objet de l'invention, on peut utiliser un guide d'ondes à deux ports tel que représenté à la figure 4 dans lequel on enregistre d'abord l'évolution temporelle de la tension $V_1(t)$ relevée au port 4a, pour une position quelconque de l'objet sous test 1, et dans lequel on mesure ensuite l'évolution temporelle de la tension $V_2(t)$ relevée au port 4b, sans que l'on ait au préalable modifié la position de l'objet sous test 1. Ces enregistrements de tension sont ensuite exploités de manière analogue à l'exploitation prévue selon les deuxième ou troisième variante objet de l'invention. On aura préférentiellement recours à cette quatrième variante de l'invention plutôt qu'à la deuxième ou à la troisième variante lorsqu'il n'est pas souhaitable de modifier le positionnement de l'objet sous test à cause de son poids ou de ses conditions de fonctionnement.

L'organigramme présenté à la figure 8 résume la description du procédé objet de l'invention selon cette quatrième variante pour une position quelconque de l'objet sous test. Sur cette figure, on voit les étapes 801 à 811 précisées comme suit :

801 : Positionnement de l'objet sous test ;

802 : Détermination des paramètres d'enregistrement temporel ;

803 : Configuration de l'enregistreur ;

804 : Enregistrement de la tension $V_1(t)$ sur un des deux ports ;

805 : Enregistrement de la tension $V_2(t)$ sur l'autre port ;

806 : Connaissance des courants $I_j(t)$ ;

807 : Détermination des tensions $V_a(t)$ et $V_b(t)$ par corrélation des tensions $V_1(t)$ et $V_2(t)$ en connaissance des courants $I_j(t)$ ;

808 : Détermination des moments électriques $M_{ez}(t)$ et des moments magnétiques $M_{mx}(t)$ à partir des tensions $V_a(t)$ et $V_b(t)$ ;

809 : Détermination des longueurs équivalentes de segments de conducteurs virtuels $L_j$ et des retards $\tau_j$ par identification des courants $I_j(t)$ dans les moments électriques $M_{ez}(t)$ ;

810 : Détermination des surfaces équivalentes de boucles de conducteurs virtuels $S_j$ et des retards $\tau_j$ par identification des courants $I_j(t)$ dans les moments magnétiques $M_{mx}(t)$.

811 : Affichage et interprétation des résultats pour la position de l'objet sous test.

Les étapes 801 à 803 correspondent à l'initialisation, les étapes 804 et 805 correspondent à l'enregistrement et les étapes 806 à 810 correspondent au traitement numérique.

Quelle que soit la variante utilisée pour mettre en oeuvre le procédé objet de l'invention, ce procédé exploite l'enregistrement temporel de deux mesures de tension au(x) port(s) d'un guide d'ondes transverses électromagnétiques. Dans les première et quatrième variantes du procédé objet de l'invention, les résultats obtenus sont relatifs à la position arbitrairement choisie de l'objet sous test 1 placé de préférence à égales distances des ports du guide d'ondes. Dans les deuxième, troisième, cinquième et sixième variantes du procédé objet de l'invention, les résultats obtenus sont relatifs à la position initiale arbitrairement choisie de l'objet sous test 1 placé à une distance quelconque du port du guide d'ondes sur lequel s'effectue la mesure.

En pratique, il convient de procéder à n répétitions de ces enregistrements temporels en modifiant le positionnement de l'objet sous test 1 afin de porter un diagnostic aussi complet que possible sur les causes de rayonnement de l'objet sous test.

Le procédé objet de l'invention est ainsi caractérisé par la connaissance des évolutions temporelles de chaque courant véhiculé dans les conducteurs de l'objet sous test alimenté, par l'enregistrement temporel de 2n mesures de tensions au(x) port(s) du guide d'ondes transverses électromagnétiques ainsi que par le traitement de ces courants et de ces mesures de tension qui conduisent à la détermination de grandeurs géométriques élémentaires caractéristiques du pouvoir rayonnant de chaque courant véhiculé. Les diverses variantes du procédé objet de l'invention se distinguent par le nombre de ports du guide d'ondes transverses électromagnétiques utilisé pour les mesures de tension, par l'axe de rotation de l'objet sous test et par le nombre de positionnement de l'objet dans le guide d'ondes qui en résulte.

**Revendications**

**1.** Procédé de mesure et de diagnostic du rayonnement électromagnétique d'un objet (1) dont les conducteurs sont parcourus par des courants, placé dans un guide d'ondes transverses électromagnétiques (3) comportant au moins un port (4), **caractérisé en ce que** l'on prend en compte les évolutions temporelles desdits courants, on réalise un enregistrement temporel de 2n mesures de tension sur le(s) port(s) (4) du guide d'ondes transverses électromagnétiques et on traite numériquement les valeurs desdits courants et desdites mesures de tension pour déterminer des grandeurs géométriques élémentaires caractéristiques du pouvoir rayonnant de chaque courant véhiculé, à savoir des longueurs équivalentes de segments de conducteurs virtuels et les surfaces équivalentes de boucles de conducteurs virtuels.

2. Procédé selon la revendication 1, **caractérisé en ce que** l'on utilise un guide d'ondes transverses électromagnétiques à deux ports (4a) (4b).

3. Procédé selon la revendication 2, **caractérisé en ce que** l'on procède à l'enregistrement simultané des tensions recueillies sur chacun des deux ports (4a) (4b) du guide d'ondes transverses électromagnétiques, cet enregistrement étant répété pour n positionnements de l'objet dans le guide d'ondes.

4. Procédé selon la revendication 2, **caractérisé en ce que** l'on procède à l'enregistrement de la tension recueillie sur un seul des deux ports (4a) du guide d'ondes transverses électromagnétiques, ce port étant choisi arbitrairement et cet enregistrement étant répété pour n couples de deux positionnements de l'objet dans le guide d'ondes, deux positionnements d'un même couple se déduisant l'un de l'autre par une rotation de 180 degrés autour de l'axe du vecteur champ électrique.

5. Procédé selon la revendication 2, **caractérisé en ce que** l'on procède à l'enregistrement de la tension recueillie sur un seul des deux ports (4a) du guide d'ondes transverses électromagnétiques, ce port étant choisi arbitrairement et cet enregistrement étant répété pour n couples de deux positionnements de l'objet dans le guide d'ondes, deux positionnements d'un même couple se déduisant l'un de l'autre par une rotation de 180 degrés autour de l'axe du vecteur champ magnétique.

6. Procédé selon la revendication 2, **caractérisé en ce que** l'on procède à l'enregistrement de la tension recueillie sur l'un des deux ports (4a) du guide d'ondes transverses électromagnétiques, puis à l'enregistrement de la tension recueillie sur l'autre port (4b), sans changer le positionnement de l'objet sous test, ce couple d'enregistrements étant répété pour n positionnements de l'objet dans le guide d'ondes transverses électromagnétiques.

7. Procédé selon la revendication 1, **caractérisé en ce que** l'on utilise un guide d'ondes transverses électromagnétiques à un port (4).

8. Procédé selon la revendication 7, **caractérisé en ce que** l'on procède à l'enregistrement de la tension recueillie sur le port (4), cet enregistrement étant répété pour n couples de deux positionnements de l'objet dans le guide d'ondes transverses électromagnétiques, ces deux positionnements se déduisant l'un de l'autre par une rotation de 180 degrés autour de l'axe du vecteur champ électrique.

9. Procédé selon la revendication 7, **caractérisé en ce que** l'on procède à l'enregistrement de la tension recueillie sur le port (4), cet enregistrement étant répété pour n couples de deux positionnements de l'objet dans le guide d'ondes transverses électromagnétiques, ces deux positionnements se déduisant l'un de l'autre par une rotation de 180 degrés autour de l'axe du vecteur champ magnétique.

**Claims**

1. Method of measurement and diagnosis of the electromagnetic radiation from an object (1), the conductors of which are traversed by currents, the object being placed in a transverse-electromagnetic-wave guide (3) including at least one port (4), **characterized in that** account is taken of the time-based changes in the said currents, a time-based recording is taken of 2n voltage measurements on the port(s) (4) of the transverse-electromagnetic-wave guide, and the values of the said currents and of the said voltage measurements are processed digitally in order to determine basic geometric magnitudes characteristic of the radiating power of each current transported, namely equivalent lengths of segments of virtual conductors and the equivalent surface areas of loops of virtual conductors.

2. Method according to Claim 1, **characterized in that** a transverse-electromagnetic-wave guide is used, having two ports (4a) (4b) .

3. Method according to Claim 2, **characterized in that** a simultaneous recording is taken of the voltages picked up on each of the two ports (4a) (4b) of the transverse-electromagnetic-wave guide, this recording being repeated for n positionings of the object in the waveguide.

4. Method according to Claim 2, **characterized in that** a recording is taken of the voltage picked up on only one of the two ports (4a) of the transverse-electromagnetic-wave guide, this port being chosen arbitrarily and this recording being repeated for n pairs of two positionings of the object in the waveguide, two positionings of the same pair being deduced from one another by a rotation by 180 degrees about the axis of the electric field vector.

5. Method according to Claim 2, **characterized in that** a recording is taken of the voltage picked up on only one of the two ports (4a) of the transverse-electromagnetic-wave guide, this port being chosen arbitrarily and this recording being repeated for n pairs of two positionings of the object in the waveguide, two positionings of the same pair being deduced from one another by a rotation by 180 degrees about the axis of the magnetic field vector.

6. Method according to Claim 2, **characterized in that** a recording is taken of the voltage picked up on one of the two ports (4a) of the transverse-electromagnetic-wave guide then a recording is taken of the voltage picked up on the other port (4b), without changing the positioning of the object under test, this pair of recordings being repeated for n positionings of the object in the transverse-electromagnetic-wave guide.

7. Method according to Claim 1, **characterized in that** a transverse-electromagnetic-wave guide having one port (4) is used.

8. Method according to Claim 7, **characterized in that** a recording is taken of the voltage picked up on the port (4), this recording being repeated for n pairs of two positionings of the object in the transverse-electromagnetic-wave guide, these two positionings being deduced from one another by a rotation by 180 degrees about the axis of the electric field vector.

9. Method according to Claim 7, **characterized in that** a recording is taken of the voltage picked up on the port (4), this recording being repeated for n pairs of two positionings of the object in the transverse-electromagnetic-wave guide, these two positionings being deduced from one another by a rotation by 180 degrees about the axis of the magnetic field vector.


**Patentansprüche**

1. Verfahren zur Messung und Diagnose von elektromagnetischer Strahlung eines Objektes (1), dessen Leitungen von Strömen durchflossen sind und das in einem Leiter für transversale elektromagnetische Wellen (3) angeordnet ist, der wenigstens einen Anschluss (4) aufweist, **dadurch gekennzeichnet, dass** man die zeitlichen Entwicklungen der Ströme berücksichtigt, man eine zeitliche Aufzeichnung von 2n Spannungsmessungen an dem Anschluss (den Anschlüssen) (4) des Leiters für transversale elektromagnetische Wellen durchführt und man die Werte der Ströme und der Spannungsmessungen numerisch verarbeitet, um die charakteristischen elementaren geometrischen Größen des Strahlungsvermögens jedes übertragenen Stroms zu bestimmen, das heißt die äquivalenten Längen der virtuellen Leitungssegmente und die äquivalenten Flächen der virtuellen Leitungsschleifen.

2. Verfahren gemäß Anspruch 1, **dadurch gekennzeichnet, dass** man einen Leiter für transversale elektromagnetische Wellen mit zwei Anschlüssen (4a) (4b) verwendet.

3. Verfahren gemäß Anspruch 2, **dadurch gekennzeichnet, dass** man die an jedem der beiden Anschlüsse (4a) (4b) des Leiters für transversale elektromagnetische Wellen gemessenen Spannungen gleichzeitig aufzeichnet, wobei die Aufzeichnung für n Positionierungen des Objektes in dem Wellenleiter wiederholt wird.

4. Verfahren gemäß Anspruch 2, **dadurch gekennzeichnet, dass** man die an einem einzigen der beiden Anschlüsse (4a) des Leiters für transversale elektromagnetische Wellen gemessene Spannung aufzeichnet, wobei man den Anschluss willkürlich wählt und die Aufzeichnung für n Paare von zwei Positionierungen des Objektes in dem Wellenleiter wiederholt wird, wobei die beiden Positionierungen desselben Paares durch eine Drehung um 180° um die Achse des elektrischen Feldvektors auseinander hervorgehen.

5. Verfahren gemäß Anspruch 2, **dadurch gekennzeichnet, dass** man die an einem einzigen der beiden Anschlüsse (4a) des Leiters für transversale elektromagnetische Wellen gemessene Spannung aufzeichnet, wobei man den Anschluss willkürlich wählt und die Aufzeichnung für n Paare von zwei Positionierungen des Objektes in dem Wellenleiter wiederholt wird, wobei die beiden Positionierungen desselben Paares durch eine Drehung um 180° um die Achse des magnetischen Feldvektors auseinander hervorgehen.

6. Verfahren gemäß Anspruch 2, **dadurch gekennzeichnet, dass** man die an einem der beiden Anschlüsse (4a) des Leiters für transversale elektromagnetische Wellen gemessene Spannung aufzeichnet, dann die an dem anderen Anschluss (4b) gemessene Spannung aufzeichnet, ohne die Positionierung des zu untersuchenden Objektes zu ändern, wobei dieses Aufzeichnungspaar für n Positionierungen des Objektes in dem Leiter für transversale elektromagnetische Wellen wiederholt wird.

7. Verfahren gemäß Anspruch 1, **dadurch gekennzeichnet, dass** man einen Leiter für transversale elektromagnetische Wellen mit einem Anschluss (4) verwendet.

8. Verfahren gemäß Anspruch 7, **dadurch gekennzeichnet, dass** man die an dem Anschluss (4) gemessene Spannung aufzeichnet, wobei die Aufzeichnung für n Paare von zwei Positionierungen des Objektes in dem Leiter für transversale elektromagnetische Wellen wiederholt wird, wobei die beiden Positionierungen durch eine Drehung um 180° um die Achse des elektrischen Feldvektors auseinander hervorgehen.

9. Verfahren gemäß Anspruch 7, **dadurch gekennzeichnet, dass** man die an dem Anschluss (4) gemessene Spannung aufzeichnet, wobei die Aufzeichnung für n Paare von zwei Positionierungen des Objektes in dem Leiter für transversale elektromagnetische Wellen wiederholt wird, wobei die beiden Positionierungen durch eine Drehung um 180° um die Achse des magnetischen Feldvektors auseinander hervorgehen.

Fig. 1

Fig. 2

Fig. 3

Fig. 4

Fig. 5

Fig. 6

Fig. 7

```
┌─────────────────────────────┐
│             801             │
└─────────────────────────────┘
               │
               ▼
     ┌───────────────────┐
     │        802        │
     └───────────────────┘
               │
               ▼
   ┌───────────────────────┐
   │          803          │
   └───────────────────────┘
               │
               ▼
     ┌───────────────────┐
     │        804        │
     └───────────────────┘
               │
               ▼
   ┌───────────────────────┐
   │          805          │
   └───────────────────────┘
               │
               │
┌──────────────────┐        │
│       806        │        │
└──────────────────┘        │
         │                  │
         ▼                  ▼
┌────────────────────────────────────┐
│                807                 │
└────────────────────────────────────┘
               │
               ▼
   ┌─────────────────────────┐
   │           808           │
   └─────────────────────────┘
         │               │
         ▼               ▼
┌──────────────┐  ┌──────────────┐
│     809      │  │     810      │
└──────────────┘  └──────────────┘
         │               │
         ▼               ▼
   ┌──────────────────────────┐
   │           811            │
   └──────────────────────────┘
```

Fig. 8

16

Fig. 9a

Fig. 9b

Fig. 10a

Fig. 10b

Fig. 10c

Fig. 11

Fig. 12a

Fig. 12b

Fig. 13a

Fig. 13b

Fig. 14a

Fig. 14b

Fig. 15a

Fig. 15b